(19) Europäisches Patentamt
European Patent Office
Office européen des brevets

(11) **EP 3 522 168 A1**

(12) **EUROPEAN PATENT APPLICATION**

(43) Date of publication:
**07.08.2019 Bulletin 2019/32**

(51) Int Cl.:
*G11C 29/52* (2006.01)    *G06F 11/10* (2006.01)

(21) Application number: **19150434.9**

(22) Date of filing: **04.01.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.02.2018 US 201815890204**

(71) Applicant: **INTEL Corporation
Santa Clara, CA 95054 (US)**

(72) Inventors:
• **CRISS, Kjersten E.
Beaverton, OR 97005 (US)**
• **WU, Wei
Portland, OR 97229 (US)**

(74) Representative: **Rummler, Felix
Maucher Jenkins
26 Caxton Street
London SW1H 0RJ (GB)**

(54) **SHARED PARITY CHECK FOR CORRECTING MEMORY ERRORS**

(57)    Examples include techniques for implementing read and write operations between a memory controller and a memory device. In an embodiment, the memory controller is configured to receive data bits to write to the memory device, to determine, using a memory controller ECC component and the data bits, a plurality of memory controller ECC check bits and one or more parity bits, to append the memory controller ECC check bits and the one or more parity bits to the data bits, and to send the data bits, the memory controller ECC check bits, and the one or more parity bits to the memory device during a write operation. In an embodiment, the memory controller is configured to receive the data bits and the memory controller ECC check bits from the memory device, to check the data bits against the memory controller ECC check bits and correct errors detected, and to return the data bits during a read operation.

Fig. 2

EP 3 522 168 A1

**Description**

**TECHNICAL FIELD**

Examples described herein are generally related to techniques for correcting errors in a memory.

**BACKGROUND**

Error correction codes (ECC) may be used to detect errors in data. In some new memory types such as fifth generation Double Data Rate Synchronous Dynamic Random-Access Memory (DRAM), known as DDR5, and third generation High Bandwidth Memory (HBM), known as HBM3, circuitry for "in-DRAM" ECC, also called an on-die ECC component, may be included in HBM3 and DDR5 memories to increase yield by correcting errors from single cell defects or weak-bits. The on-die ECC component uses a single error correction (SEC) code and can miss-correct, or alias a bit, when two or more errors are present. In DDR-type Dual Inline Memory Modules (DIMMs), the errors are confined to a single device which only reads out a portion of the total cache-line, and thus are correctable or detectable by many memory controller ECC schemes even if the on-die ECC component miss-corrects. However, in HBM devices, the entire cache-line is read from a single device and therefore errors may be distributed over the entire cache-line. If a multi-bit error is present, the on-die ECC component could miss-correct an additional bit anywhere within the affected on-die ECC region. For example, a multi-bit error confined to a column (a possible error pattern for a column select failure), would turn into a column error and additional random bit errors from on-die ECC the component miss correcting in the on-die ECC regions affected by the column select failure, or an error from a single cell fault (the most common type of DRAM failure) aligned with a soft single bit error, would become a random triple bit error dispersed over the cache-line.
There is no known solution to address on-die ECC miss-corrections in memories where the cache-line is obtained from a single device, such as a HBM device, or other memory devices that retrieve an entire cache line from a single memory device, when multi-bit errors are present.

**BRIEF DESCRIPTION OF THE DRAWINGS**

FIG. 1 illustrates an example memory controller and memory device arrangement.
FIG. 2 illustrates an example data flow of a read operation.
FIG. 3 illustrates an example first diagram of a data layout.
FIG. 4 illustrates an example second diagram of a data layout.
FIG. 5 illustrates an example third diagram of a data layout.
FIG. 6 illustrates an example fourth diagram of a data layout.
FIG. 7 illustrates an example of a logic flow of a write operation for a memory controller.
FIG. 8 illustrates an example of a logic flow of a write operation for a memory device.
FIG. 9 illustrates an example of a logic flow of a read operation for a memory device.
FIG. 10 illustrates an example of a logic flow of a read operation for a memory controller.
FIG. 11 illustrates an example computing platform.

**DETAILED DESCRIPTION**

One approach to error correction is to have memory controller ECC circuitry attempt to correct or detect any additional errors caused by an on-die ECC component, while simultaneously attempting to detect or correct the original multi-bit errors. This approach significantly and negatively impacts the reliability of the HBM3 or similar devices and makes any error detection and correction by the memory controller ECC unreliable. Since single bit errors are corrected by the on-die ECC component, the memory controller ECC is mainly exposed to multi-bit errors, the error types that the on-die ECC component may miss-correct. In addition, a memory exhibiting a higher number of single cell faults and weak-bits increases the possibility of double bit errors caused by soft errors aligning with single cell faults or weak-bits. The memory controller ECC would need to provide random triple bit error correction to fully protect against soft errors. Random triple bit error correction causes additional latency during error correction and requires two additional error correction symbols when compared to random double bit error correction. To provide protection from other error types (e.g., column select error, lane error, etc.) the memory controller ECC would have to support correction/detection of the original multi-bit error pattern and additional random single bit errors caused by on-die ECC. Each additional error caused by the on-die ECC component increases correction latency and requires at least two additional ECC symbols, thereby increasing the complexity of the circuitry.

ECC-protected memory devices may employ symbol based ECCs that calculate a bit-wise parity over a cache-line. These solutions may be implemented in a variety of ways, but some conditions will be imposed on the data, meta-data, and ECC bits written to a cache-line. When the memory checks this data with an on-die ECC component, the memory can also check the parity conditions to ensure that error correction is only done when single bit errors are present in order to prevent miss-correction by the on-die ECC component.

Thus, by sharing a portion of the external ECC bits that a computing platform uses for memory device correction ("external" meaning outside of the memory device) with the internal ECC correction scheme used by the memory device, improved error detection and correction capabilities may be provided.

Embodiments of the present invention improve the reliability of HBM3 and other memory devices using on-die ECCs and similar parity structures. Miss-correction by the on-die ECC component either seriously compromises the ability of the memory controller ECC component to recover from multi-bit errors or drastically increases the number of ECC bits needed for correction and the latency of correction. Embodiments of the present invention may be used to increase the reliability of HBM3 or similar memory devices and reduce the cost and latency of error corrections.

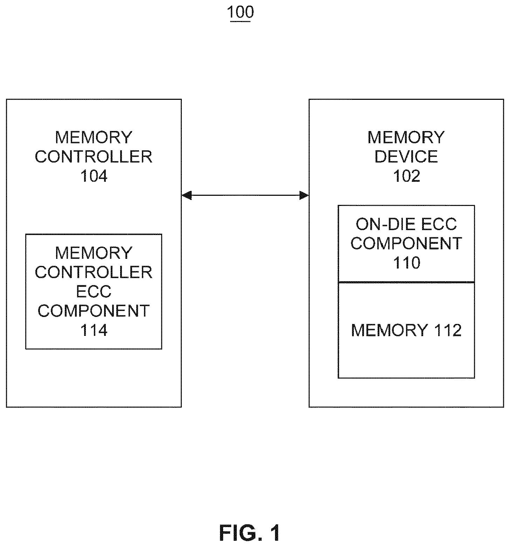

**FIG. 1** illustrates an example memory controller and memory device arrangement 100. In some examples, as shown in FIG. 1, arrangement 100 includes a memory device 102, including an on-die ECC component 110 and memory 112. The memory device 102 may be communicatively coupled to a memory controller 104.

In some examples, memory 112 may include volatile types of memory including, but not limited to, RAM, D-RAM, DDR SDRAM, SRAM, T-RAM or Z-RAM. One example of volatile memory includes DRAM, or some variant such as SDRAM. A memory as described herein may be compatible with a number of memory technologies, such as HBM (HIGH BANDWIDTH MEMORY DRAM, JESD235, originally published by Joint Electron Device Engineering Council (JEDEC) Solid State Technology Association (JEDEC) in October 2013) and DDR5 (DDR version 5, currently in discussion by JEDEC), and/or others, and technologies based on derivatives, revisions, versions or extensions of such specifications.

On-die ECC component 110 comprises logic to detect and correct errors in data in memory 112. Memory controller 104 may be arranged to control access to data at least temporarily stored at memory device 102. Although only one memory device is shown in the example of FIG. 1, it should be understood that in other examples multiple memory devices may be controlled by memory controller 104. Memory controller 104 may comprise a memory controller ECC component 114 to detect and correct errors in data obtained from memory 112.

Embodiments of the present invention provide a method and apparatus to avoid on-die ECC miss-correction by providing parity conditions to on-die ECC component 110 that may be checked to ascertain if a multi-bit error is present and halt on-die ECC correction when multi-bit errors are present.

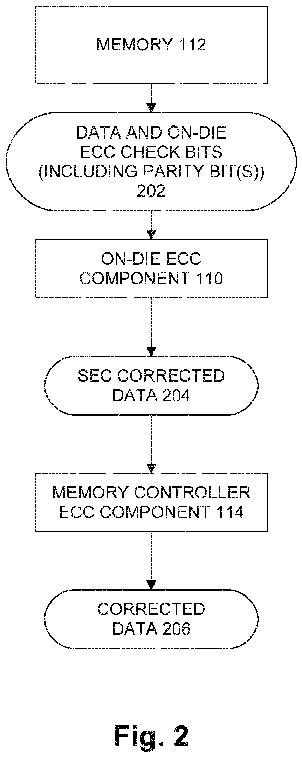

**FIG.2** illustrates an example data flow of a read operation. Data and on-die ECC check bits 202 may be read out of memory 112 by on-die ECC component 110. Data and on-die ECC check bits 202 may include one or more parity bits. On-die ECC component 110 may detect and correct errors in the data based on analyzing the on-die ECC check bits to generate single error correcting code (SEC) data 204. However, miss-correction of errors may be introduced by on-die ECC component 110. Memory controller ECC component 114 detects and corrects these miss-corrections and produces corrected data 206.

Parity bits used in an ECC scheme impose conditions on the data and the external ECC check bits written to memory 112. For example, a bit-wise parity over all bursts of data signaled over I/O data lines from memory 112 may be appended to the data as part of the external ECC code. The effect of this parity is the condition that the exclusive-OR operation (XOR) of all bits in a burst is zero.

In embodiments of the present invention, memory controller 104 may generate memory controller ECC check bits (including parity bits) when a write occurs and those bits are stored with the data in memory device 102. When a read occurs, memory device 102 fetches the data and the on-die ECC check bits together and processes the data and the on-die ECC check bits by on-die ECC component 110. Next, all of the bits are sent as SEC corrected data 204 to memory controller 104 where memory controller ECC component 114 checks for inconsistencies between the data and the memory controller ECC check bits and, if required, performs a correction. The memory controller receives a data word (generally there are no restrictions on the data patterns) and based on an encoding scheme generates memory controller ECC check bits and appends them onto the data bits forming a code word. An invalid code word (i.e. data and check bits are not consistent with one another) indicates an error in either the data, the check bits, or both. The memory controller ECC component than tries to find the code word that is the closest to the invalid word that was received. If the error is correctable by the memory controller ECC component then the original code word can be found and the data is recovered. If the error is not correctable than one of two things happens: the invalid code word is too far away from a valid code word and is not correctable (e.g., a detectable uncorrectable error (DUE)) or the invalid code is too close to another code word and is mis-corrected (e.g., a silent data corruption (SDC)). The distance between code words can be defined in different ways depending on the code. For example, a SEC code looks at a Hamming distance and will attempt to correct if the invalid code word is Hamming distance 1 from a valid code word (in this case, when the code word is Hamming distance 1 from another code word, the error syndrome is equal to a column of the h-matrix). The memory controller ECC component may use a burst error correction code, this type of code uses some information about the type of expected errors to inform how the distance metric is determined. For example, one of these codes may expect errors to be limited to blocks of 16 bits instead of spread randomly over the code word. For burst error correction codes, finding the closest code word to the received code word may be more complicated than for the hamming codes.

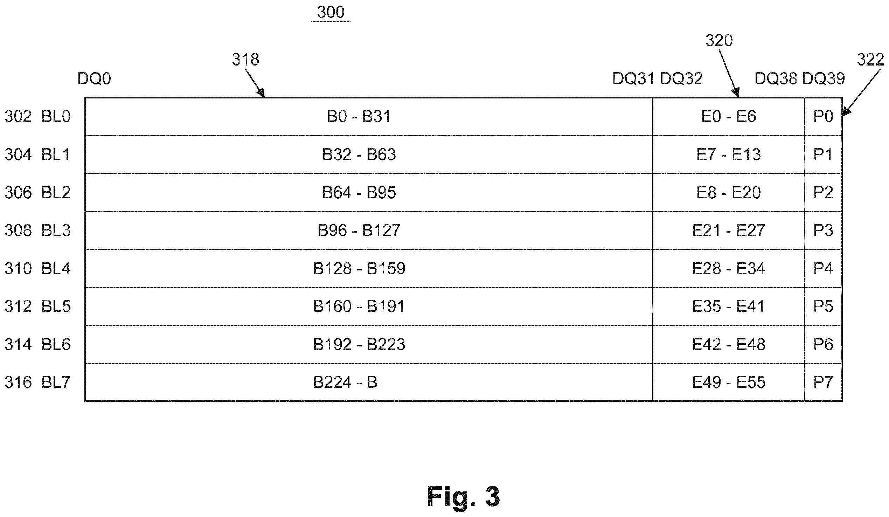

**FIG. 3** illustrates an example first diagram of a data layout. In this example, FIG. 3 shows a HBM3 ½ cacheline bit layout with bit-wise parity over all bursts. In embodiments, this data layout may be used for data and external ECC check and parity bits, or metadata bits. In this example, a set of bursts 300 comprises eight bursts BL0, BL1, BL2, BL3, BL4, BL5, BL6, and BL7, labeled 302, 304, 306, 308, 310, 312, 314, and 316, respectively. Each burst comprises a signaling of data over I/O data lines (e.g., cache lines) between memory device 102 and memory controller 104. Each I/O data line may be known as a DQ, numbered from DQ0 to DQ39 for a transfer of 40 bits of information. In this example, burst BL0 302 comprises 32 bits of data 318, denoted bit B0 through bit B31, external ECC check bits, additional parity bits, or metadata bits 320 comprises seven bits, denoted bit E0 through bit E6, and parity bit 322 comprises one bit, denoted bit P0. The parity bit for burst BL0 302 may be the bit-wise XOR of all bits in the burst from DQ0 to DQ38 (becoming bit 0 through bit 38 (i.e., B0 to B31 and E0 to E6)). For example, this may be specified as:

$$P0 = B0 + B1 + B2 + B3 + \ldots + B31 + E0 + E1 + E2 + \ldots + E6$$

Where the B's may be the data bits 318 in burst BL0 302, the E's may be the external ECC check bits, additional parity bits, or metadata bits 320 in burst BL0 302, and "+" represents the XOR operation.

The remaining bursts in the set 300 may be defined in a similar manner. For example, burst BL1 304 comprises 32 bits of data, denoted bit B32 through bit B63, ECC check bits comprises seven bits, denoted bit E7 through bit E13, and the parity bit comprises one bit, denoted bit P1, and so on.

Similarly, the parity for a data transfer may also be calculated over multiple bit blocks (such as is common for symbolic correction codes). For a cache-line layout like the one for HBM3, block widths of two or four may be common choices.

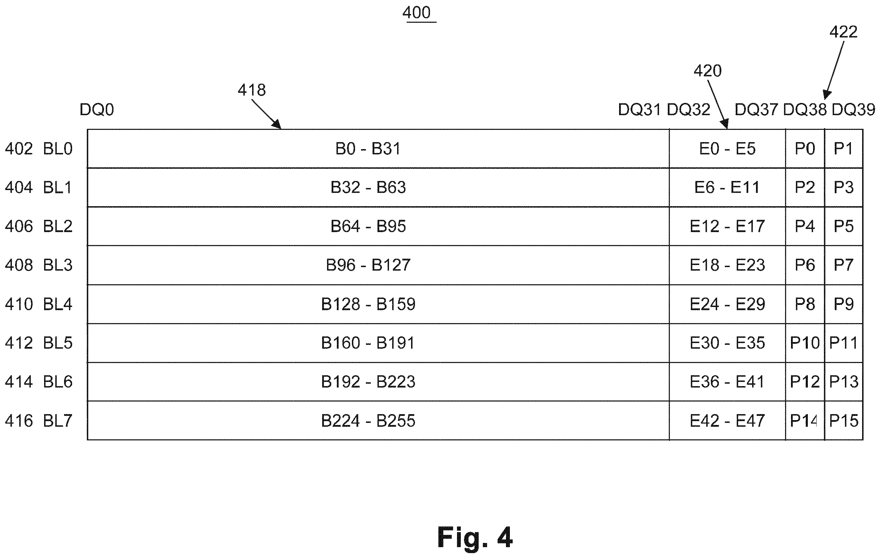

**FIG. 4** illustrates an example second diagram of a data layout. For this example, computing a parity over blocks of two-bit width in a cache-line would result in this layout. In this example, FIG. 4 shows a HBM3 ½ cache-line bit layout with bit-wise parity over all even and odd bursts. In embodiments, this data layout may be used for data and external ECC check bits, additional parity bits, or metadata bits. In this example, a set of bursts 400 comprises eight bursts BL0, BL1, BL2, BL3, BL4, BL5, BL6, and BL7, labeled 402, 404, 406, 408, 410, 412, 414, and 416, respectively. In this example, burst BL0 402 comprises 32 bits of data 418, denoted bit B0 through bit B31, external ECC check bits, additional parity bits, or metadata bits 422 comprises six bits, denoted bit E0 through bit E5, and parity bits 422 comprises two bits, denoted bit P0 and P1. The parity bits in this case for burst BL0 402 may be the bit-wise XOR of all bits in the burst from either the even DQs or the odd DQs (i.e., even numbered DQs: DQ0 to DQ36 (even numbered bits B0 to B30 and even numbered bits E0 to E4), or odd numbered DQs: DQ1 to DQ 37 (odd numbered bits B1 to B31 and odd numbered bits E1 to E5). For example, this may be specified as:

$$P0 = B0 + B2 + B4 + B6 + \ldots + B30 + E0 + E2 + E4$$

$$P1 = B1 + B3 + B5 + B7 + \ldots + B31 + E1 + E3 + E5$$

Where the B's may be the data bits 418 in burst BL0 402, the E's may be the external ECC check bits, additional parity bits, or metadata bits 420 in burst BL0 402, and "+" represents the XOR operation.

The remaining bursts in the set 400 may be defined in a similar manner.

The effect of this parity is that the XOR of all bits from even DQs in a burst is zero and the XOR of all the bits from odd DQs in a burst is zero. These conditions also imply that the XOR of all bits in a burst is zero.

A similar scheme may be used for parity over blocks with a width of four bits. In this example, a parity bit may be calculated from every fourth bit in a burst. The effect of this parity is that the XOR of the bits from every fourth DQ in a burst is zero. This implies that the XOR of bits from all the even/odd DQs in a burst is also zero, and the XOR of all bits in a burst is also zero.

Based on the memory controller ECC component 114 and the desired level of protection from on-die ECC component 110 miss-corrections, these parity conditions may be communicated to on-die ECC component 110. In an embodiment, the in-DRAM ECC engine has some prior knowledge of the parity condition being used or is able to check for parity conditions. The parity conditions are not the same as the parity bits, but they are determined by the parity bits being in the burst. For example, the equation in paragraph 28 defines the equation for P1. If P1 is appended to burst zero, the XOR of all the bits in burst zero is: P1+B0+B1+...+ E0+E1+...+E6 = (B0+ B0+B1+...+ E0+E1+...+E6)+ BO+B1+...+ E0+E1+...+E6 = (B0+B0)+(B1+B1)+...+ (E0+E0)+(E1+E1)+...+(E6+E6) = 0+0+...+0+0+...+0=0. The parity bit is just P1 and it is calculated by using the parity equation. The parity condition is the property that the sum over some portion of bits within a burst will be equal to zero. The bits that sum to zero within a burst are dependent on which parity equation was used/how many parity bits are in a burst.

In an embodiment, a level of parity conditions that may be communicated would be the fewest parity conditions that can eliminate a significant number of miss-corrections by on-die ECC component 110 when presented with a multi-bit error that would be correctable by memory controller ECC component 114. For example, if memory controller ECC component 114 may only be able to correct failures limited to a single DQ and random double bit errors, then the parity condition given to on-die ECC component 110 should be that the XOR of all bits in a burst will be zero. This will eliminate on-die ECC miss-correction of all double bit errors and errors confined to a single DQ, but it would not eliminate miss-correction of triple bit or greater errors that are not confined to a single DQ, but the triple-bit or greater errors not confined to a DQ cannot be reliably corrected or detected by the memory controller ECC component 114 anyway.

On-die ECC component 110 may also calculate the values of parity for whichever parity condition exists in the data in parallel with the SEC code calculations. If there is a single bit error present in the bits stored in memory 112, there are two conditions that will be present in the results of the parity calculations performed by on-die ECC component 110:

(1) The parity calculations results will show exactly one burst that does not satisfy the parity conditions.
(2) The bad bit identified by on-die ECC component 110 will be contained within the burst, and if applicable, the portion of the burst (e.g., the odd portion or even portion of the burst), that does not satisfy the parity conditions (i.e., calculating the parity after correction would result in all bursts satisfying the parity conditions).

If either of these conditions are not met, on-die ECC component 110 should abandon correction because a multi-bit error is present and on-die ECC correction will cause additional errors in the data. These two conditions are enough to eliminate all miss-correction by on-die ECC component 110 in the case of double errors and all or most miss-corrections for larger granularity errors. Two example cases for double bit errors are shown below.

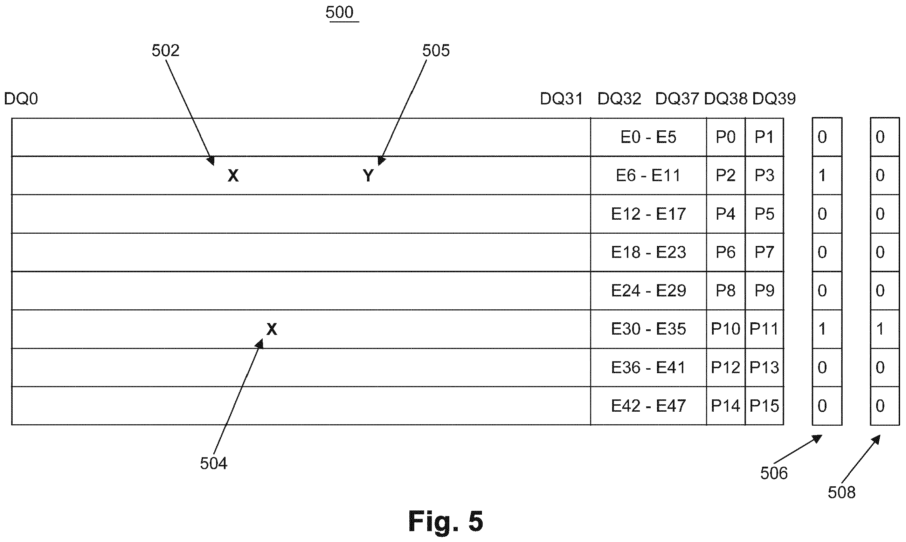

**FIG. 5** illustrates an example third diagram of a data layout 500. Fig. 5 shows two single bit errors 502, 504 in a cache-line that are in separate bursts but in the same on-die ECC correction region. Error 502 may be detected by on-die ECC component 110 but mis-corrected at bit 505. The resulting parity check 506 shows two ones, violating the first single bit error condition ((1) above), and the parity after correction 508 is not all zero, violating the second single bit error condition ((2) above).

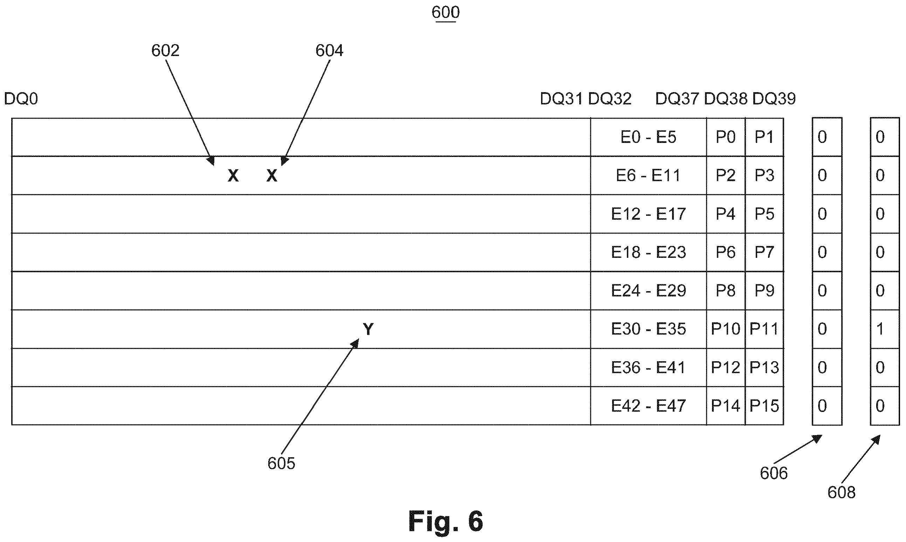

**FIG. 6** illustrates an example fourth diagram of a data layout 600. Fig. 6 shows two single bit errors 602, 604 in the same burst, with on-die ECC component 110 incorrectly detecting an error at 605. The resulting parity check 606 shows all zeros, violating the first single bit error condition, and the parity after correction 608 is again not zero, violating the second single bit error condition.

In embodiments of the present invention, such mis-corrections may be detected and fixed.

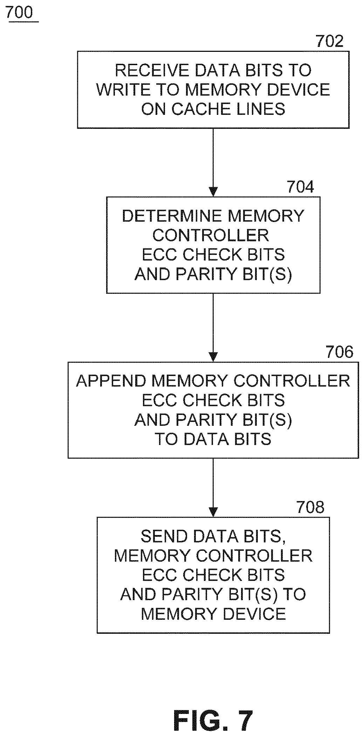

**FIG. 7** illustrates an example of a logic flow 700 of a write operation for memory controller 104. A logic flow may be implemented in software, firmware, and/or hardware. In software and firmware embodiments, a logic flow may be implemented by computer executable instructions stored on at least one non-transitory computer readable medium or machine readable medium, such as an optical, magnetic or semiconductor storage. At block 702, memory controller 104 receives data bits to write to memory device 102 over cache lines as is known in the computer arts. In embodiments of the present invention, the data bits may be received from a processor, a hard disk drive, or other components within a computing platform. In an embodiment, the number of data bits received may be 512, although in other computing platforms other amounts may be received, such as 8, 16, 32, 64, 128, 256, 1024 and so on. At block 704, memory controller 104, using memory controller ECC component 114, determines a plurality of memory controller ECC check bits and one or more parity bit(s) for the received data bits. At block 706, the memory controller ECC check bits and the parity bit(s) may be appended to the data bits (as shown in the examples of Figures 3 and 4). At block 708, the memory controller sends the data bits, the memory controller ECC check bits, and the parity bit(s) to memory device 102.

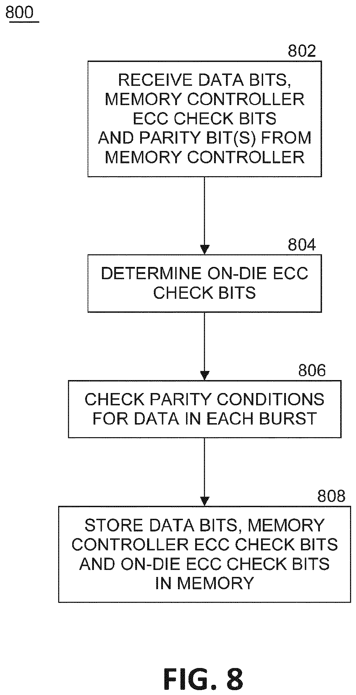

**FIG. 8** illustrates an example of a logic flow 800 of a write operation for memory device 102. At block 802, memory device 102 receives the data bits, the memory controller ECC check bits, and the one or more parity bit(s) from memory controller 104. At block 804, memory device 102, using on-die ECC component 110, determines the on-die ECC check bits for the received data bits. In an embodiment, on-die ECC check bits may be determined using XOR trees. In an embodiment, on-die ECC component 110 may calculate eight on-die ECC check bits for every 128 data bits and 16 memory controller ECC check bits received from memory controller 104. In an embodiment, the on-die ECC may be a (128 bits + 16 bits) / 8 bits SEC code. In another embodiment, on-die ECC component 110 may calculate 16 on-die ECC check bits for every 256 data bits and 32 memory controller ECC check bits received from memory controller 104. In an embodiment, the on-die ECC may be a (256 bits + 32 bits) / 16 bits SEC code. In embodiments, a SEC code may be applied enough times to process all data bits received from the memory controller. At block 806, memory device 102 may optionally check the parity conditions for the data bits in each data burst. At block 808, memory device 102 stores the data bits, the memory controller ECC check bits, and the on-die ECC check bits in memory 112. In an embodiment, the memory controller ECC check bits may be stored with the data in the memory device and simply treated as data by the memory device for purposes of storage and on-die ECC correction.

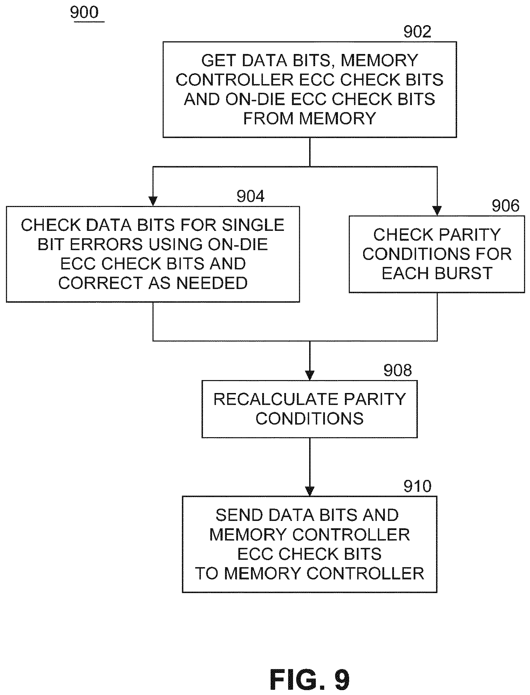

**FIG. 9** illustrates an example of a logic flow 900 of a read operation for memory device 102. At block 902, when reading data from the memory device is requested, memory device 102 gets the data bits, the memory controller ECC check bits, and the on-die ECC check bits from memory 112. At block 904, memory device, using on-die ECC component 110, checks the data bits for single bit errors using the on-die ECC check bits and corrections may be applied as needed.

In an embodiment, an H-matrix may be multiplied with a received code-word to obtain an on-die ECC error syndrome. The on-die ECC error syndrome is generally defined as the H-matrix multiplied with the received code-word (received data (with respect to the error correction code) appended with the error correction code check-bits). $H \times \overrightarrow{cw}$ = *error syndrome.* In an embodiment, the on-die ECC error syndrome may be a vector that has length equal to the number of check bits. In an embodiment, the on-die ECC error syndrome may be generated by a SEC decoder. The on-die ECC error syndrome may then be compared to the columns of the H-matrix and if a bit is equal to a column in the H-matrix, the corresponding bit is flipped.

In an embodiment, if an on-die ECC error syndrome is zero, then the memory device does not alter the data bits. If the on-die ECC error syndrome is non-zero and indicates a detectable uncorrectable error (DUE), then the memory device does not alter the data bits. A DUE occurs when the error correction code identifies an error (i.e., the error syndrome is non-zero), but the on-die ECC component cannot identify the error location (the error syndrome does not correspond to a correctable error pattern). For SEC codes like the ones used in on-die ECC, this may occur in approximately 50% of multi-bit errors, since there are about twice as many error syndromes as bits in the code word. In another embodiment, the on-die ECC component may check that the parity syndrome has a weight of 1, and if so, the one-die ECC component corrects the errors without further checking of parity conditions.

If the on-die error ECC syndrome indicates a single bit error the memory device checks the parity calculations. The on-die ECC syndrome would indicate a single bit error if the on-die ECC syndrome was equal to a column of the on-die ECC code H-matrix (i.e., if the received invalid code-word was Hamming distance 1 from a valid code-word). If the parity syndrome was a weight of one, then memory device may correct the error in the data bits. In embodiments, the parity syndrome may be the Hamming weight, which defines the weight of a binary vector as the number of 1's in the vector. If the parity syndrome does not have a weight of one, then the memory device does not alter the data bits. In an embodiment, the parity syndrome may be an error syndrome generated by checking for the parity conditions. The parity syndrome will have a 1 for each segment (burst, even half of burst, odd half of burst, etc.) that does not meet the parity condition.

At block 906, memory device 102 checks parity conditions for each burst. In an embodiment, blocks 904 and 906 may be processed in parallel. At block 908, memory device 102 may optionally recalculate the parity conditions after correction and check to make sure the parity syndrome is now zero. If the parity syndrome is not now zero, then memory device 102 reverses the correction at block 904. That is, if the parity conditions are not met, on-die ECC component 110 should abandon correction because a multi-bit error is present and on-die ECC correction will cause additional errors in the data bits. In an embodiment, this check may also be performed at block 904, where the memory device may check to determine if the parity was one in the same burst as the bit that the syndrome indicates is in error. At block 910, memory device sends the data bits and the memory controller ECC check bits to memory controller 104. In one embodiment, additional metadata bits may also be sent.

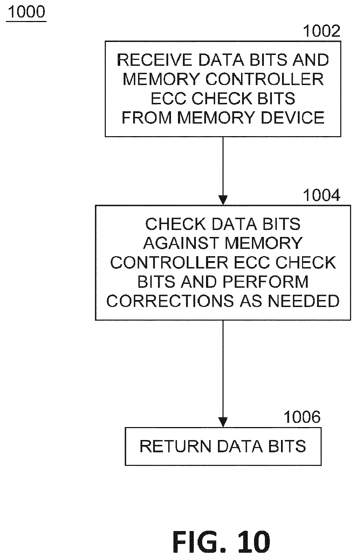

**FIG. 10** illustrates an example of a logic flow 1000 of a read operation for memory controller 104. At block 1002, memory controller 104 receives data bits and the memory controller ECC check bits from memory device 102. In one embodiment, additional metadata bits may also be received. At block 1004, the memory controller, using memory controller ECC component 114, checks the received data bits against the received memory controller ECC check bits and performs corrections as needed. At block 1006, the memory controller returns the data bits to the computer platform component requesting the data.

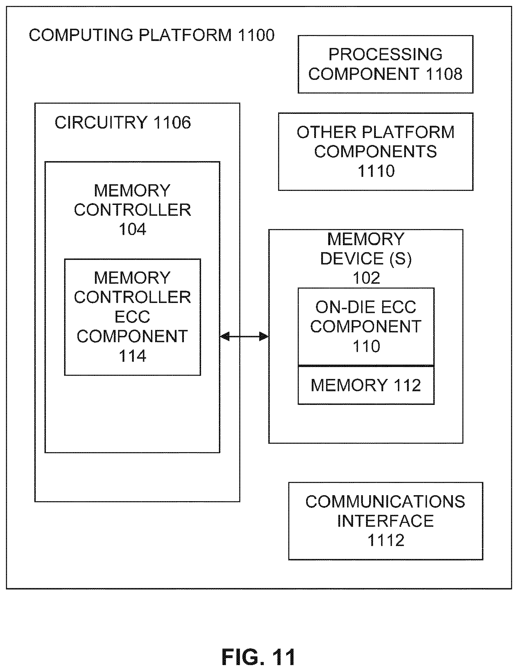

**FIG. 11** illustrates an example computing platform 1100. In some examples, as shown in FIG. 11, computing platform 1100 may comprise circuitry 1106 including a memory controller 104, memory device(s) 102, a processing component 1108, other platform components 1110 and a communications interface 1112.

According to some examples, processing component 1108 may execute processing operations or logic. Processing component 1108 may include various hardware elements, software elements, or a combination of both. Examples of hardware elements may include devices, logic devices, components, processors, microprocessors, graphics chips, circuits, processor circuits, circuit elements (e.g., transistors, resistors, capacitors, inductors, and so forth), integrated circuits, ASIC, programmable logic devices (PLD), digital signal processors (DSP), FPGA/programmable logic, memory units, logic gates, registers, semiconductor device, chips, microchips, chip sets, and so forth. Examples of software elements may include software components, programs, applications, computer programs, application programs, device drivers, system programs, software development programs, machine programs, operating system software, middleware, firmware, software components, routines, subroutines, functions, methods, procedures, software interfaces, application program interfaces (API), instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given example.

In some examples, other computing platform components 110 may include common computing elements or circuitry, such as one or more processors, multi-core processors, coprocessors, memory units, chipsets, controllers, interfaces, oscillators, timing devices, power supplies, hard disk drives (HDDs), and so forth. Examples of memory units 112 may include without limitation various types of computer readable and/or machine readable storage media in the form of one or more higher speed memory units, such as read-only memory (ROM), RAM, DRAM, DDR DRAM, synchronous DRAM (SDRAM), DDR SDRAM, DDR5, HBM3, SRAM, programmable ROM (PROM), EPROM, EEPROM, flash memory, ferroelectric memory, SONOS memory, polymer memory such as ferroelectric polymer memory, nanowire, FeTRAM or FeRAM, ovonic memory, phase change memory, memristers, STT-MRAM, magnetic or optical cards, 3D XPoint™, and any other type of storage media suitable for storing information.

In some examples, communications interface 1112 may include logic and/or features to support a communication interface. For these examples, communications interface 1112 may include one or more communication interfaces that operate according to various communication protocols or standards to communicate over direct or network communication links. Direct communications may occur via use of communication protocols such as SMBus, PCIe, NVMe, QPI, SATA, SAS or USB communication protocols. Network communications may occur via use of communication protocols Ethernet, Infiniband, SATA or SAS communication protocols.

The components and features of computing platform 1100 may be implemented using any combination of discrete circuitry, ASICs, logic gates and/or single chip architectures. Further, the features of computing platform 1100 may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It should be appreciated that the example computing platform 1100 shown in the block diagram of FIG. 11 may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Computing platform 1100 may be part of a computing device that may be, for example, user equipment, a computer, a personal computer (PC), a desktop computer, a laptop computer, a notebook computer, a netbook computer, a tablet, a smart phone, embedded electronics, a gaming console, a server, a server array or server farm, a web server, a network server, an Internet server, a work station, a mini-computer, a main frame computer, a supercomputer, a network appliance, a web appliance, a distributed computing system, multiprocessor systems, processor-based systems, or combination thereof. Accordingly, functions and/or specific configurations of computing platform 1100 described herein, may be included or omitted in various embodiments of computing platform 1100, as suitably desired.

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations may be stored on a tangible, machine readable medium and supplied to various customers or manufacturing facilities to load into the fabrication machines that actually make the logic or processor.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, ASICs, PLDs, DSPs, FPGAs, memory units, logic gates, registers, semiconductor device, graphics chips, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

It is emphasized that the Abstract of the Disclosure is provided to comply with 37 C.F.R. Section 1.72(b), requiring an abstract that will allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in a single example for the purpose of streamlining the disclosure. This method of disclosure is not to be interpreted as reflecting an intention that the claimed examples require more features than are expressly recited in each claim. Rather, as the following claims reflect, inventive subject matter lies in less than all features of a single disclosed example. Thus, the following claims are hereby incorporated into the Detailed Description, with each claim standing on its own as a separate example. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

**Claims**

1. An apparatus coupled to a memory device comprising:

   a memory controller error correcting code (ECC) component being configured to receive data bits to write to the memory device, the memory device including an on-die ECC component, to determine, using the data bits, a plurality of memory controller ECC check bits and one or more parity bits, to append the memory controller ECC check bits and the one or more parity bits to the data bits, and to send the data bits, the memory controller ECC check bits, and the one or more parity bits to the memory device during a write operation, and to receive the data bits and the memory controller ECC check bits from the memory device, to check the data bits against the memory controller ECC check bits and correct errors detected, and to return the data bits during a read operation.

2. The apparatus of claim 1, wherein the memory controller ECC component being configured to correct errors detected includes the memory controller ECC component being configured to eliminate on-die ECC component miss-correction of multiple bit errors.

3. The apparatus of claim 1, wherein the memory controller ECC component being configured to correct errors detected includes the memory controller ECC component being configured to eliminate errors confined to a single I/O data line.

4. A method of writing data to and reading data from a memory device comprising:

performing a write operation by receiving data bits to write to the memory device, the memory device including an on-die ECC component, determining, using the data bits, a plurality of memory controller ECC check bits and one or more parity bits, appending the memory controller ECC check bits and the one or more parity bits to the data bits, and sending the data bits, the memory controller ECC check bits, and the one or more parity bits to the memory device during a write operation; and

performing a read operation by receiving the data bits and the memory controller ECC check bits from the memory device, checking the data bits against the memory controller ECC check bits and correcting errors detected, and returning the data bits.

5. The method of claim 4, wherein correcting errors detected includes eliminating on-die ECC component miss-correction of multiple bit errors.

6. The method of claim 4, wherein correcting errors detected includes eliminating errors confined to a single I/O data line.

7. A system comprising:

a memory controller including a memory controller error correcting code (ECC) component; and
a memory device including an on-die ECC component and a memory;
the memory controller being configured to receive data bits to write to the memory device, to determine, using the memory controller ECC component and the data bits, a plurality of memory controller ECC check bits and one or more parity bits, to append the memory controller ECC check bits and the one or more parity bits to the data bits, and to send the data bits, the memory controller ECC check bits, and the one or more parity bits to the memory device; and
the memory device being configured to receive the data bits, the memory controller ECC check bits, and the one or more parity bits, to determine, using the on-die ECC component and the data bits, a plurality of on-die ECC check bits, and to store the data bits, the memory controller ECC check bits, and the on-die ECC check bits into the memory.

8. The system of claim 7, wherein the memory controller ECC component being configured to eliminate on-die ECC component miss-correction of multiple bit errors.

9. The system of claim 7, wherein the memory controller ECC component being configured to eliminate errors confined to a single I/O data line.

10. An apparatus comprising means to perform a method as claimed in any preceding claim.

11. Machine-readable storage including machine-readable instructions, when executed, to implement a method or realize an apparatus as claimed in any preceding claim.

100

| MEMORY<br>CONTROLLER<br>104 | | MEMORY<br>DEVICE<br>102 |
|---|---|---|
| MEMORY<br>CONTROLLER<br>ECC<br>COMPONENT<br>114 | | ON-DIE ECC<br>COMPONENT<br>110 |
| | | MEMORY 112 |

# FIG. 1

```
┌─────────────────────────────┐
│        MEMORY 112           │
└─────────────────────────────┘
              │
              ▼
   ╭─────────────────────────╮
   │    DATA AND ON-DIE      │
   │     ECC CHECK BITS      │
   │ (INCLUDING PARITY BIT(S))│
   │           202           │
   ╰─────────────────────────╯
              │
              ▼
┌─────────────────────────────┐
│       ON-DIE ECC            │
│     COMPONENT 110           │
└─────────────────────────────┘
              │
              ▼
   ╭─────────────────────────╮
   │     SEC CORRECTED       │
   │       DATA 204          │
   ╰─────────────────────────╯
              │
              ▼
┌─────────────────────────────┐
│    MEMORY CONTROLLER        │
│    ECC COMPONENT 114        │
└─────────────────────────────┘
              │
              ▼
   ╭─────────────────────────╮
   │      CORRECTED          │
   │       DATA 206          │
   ╰─────────────────────────╯
```

## Fig. 2

| | DQ0 | 318 | DQ31 DQ32 | 320 DQ38 DQ39 | 322 |
|---|---|---|---|---|---|
| 302 BL0 | | B0 - B31 | | E0 - E6 | P0 |
| 304 BL1 | | B32 - B63 | | E7 - E13 | P1 |
| 306 BL2 | | B64 - B95 | | E8 - E20 | P2 |
| 308 BL3 | | B96 - B127 | | E21 - E27 | P3 |
| 310 BL4 | | B128 - B159 | | E28 - E34 | P4 |
| 312 BL5 | | B160 - B191 | | E35 - E41 | P5 |
| 314 BL6 | | B192 - B223 | | E42 - E48 | P6 |
| 316 BL7 | | B224 - B | | E49 - E55 | P7 |

**Fig. 3**

EP 3 522 168 A1

400

EP 3 522 168 A1

| | DQ0 → B0 | DQ31 DQ32 | DQ37 DQ38 | DQ39 |
|---|---|---|---|---|
| 402 BL0 | B0 - B31 | E0 - E5 | P0 | P1 |
| 404 BL1 | B32 - B63 | E6 - E11 | P2 | P3 |
| 406 BL2 | B64 - B95 | E12 - E17 | P4 | P5 |
| 408 BL3 | B96 - B127 | E18 - E23 | P6 | P7 |
| 410 BL4 | B128 - B159 | E24 - E29 | P8 | P9 |
| 412 BL5 | B160 - B191 | E30 - E35 | P10 | P11 |
| 414 BL6 | B192 - B223 | E36 - E41 | P12 | P13 |
| 416 BL7 | B224 - B255 | E42 - E47 | P14 | P15 |

418   420   422

**Fig. 4**

**Fig. 5**

EP 3 522 168 A1

600

EP 3 522 168 A1

602    604

DQ0                                                        DQ31 DQ32    DQ37 DQ38 DQ39

| | E0 - E5 | P0 | P1 | 0 | 0 |
|---|---|---|---|---|---|
| X    X | E6 - E11 | P2 | P3 | 0 | 0 |
| | E12 - E17 | P4 | P5 | 0 | 0 |
| | E18 - E23 | P6 | P7 | 0 | 0 |
| | E24 - E29 | P8 | P9 | 0 | 0 |
| Y | E30 - E35 | P10 | P11 | 0 | 1 |
| | E36 - E41 | P12 | P13 | 0 | 0 |
| | E42 - E47 | P14 | P15 | 0 | 0 |

605

606

608

**Fig. 6**

700

702

RECEIVE DATA BITS TO
WRITE TO MEMORY DEVICE
ON CACHE LINES

704

DETERMINE MEMORY
CONTROLLER
ECC CHECK BITS
AND PARITY BIT(S)

706

APPEND MEMORY CONTROLLER
ECC CHECK BITS
AND PARITY BIT(S)
TO DATA BITS

708

SEND DATA BITS,
MEMORY CONTROLLER
ECC CHECK BITS
AND PARITY BIT(S) TO
MEMORY DEVICE

# FIG. 7

800

802

RECEIVE DATA BITS,
MEMORY CONTROLLER
ECC CHECK BITS
AND PARITY BIT(S) FROM
MEMORY CONTROLLER

804

DETERMINE ON-DIE ECC
CHECK BITS

806

CHECK PARITY CONDITIONS
FOR DATA IN EACH BURST

808

STORE DATA BITS, MEMORY
CONTROLLER ECC CHECK BITS
AND ON-DIE ECC CHECK BITS
IN MEMORY

# FIG. 8

900

902

GET DATA BITS, MEMORY
CONTROLLER ECC CHECK BITS
AND ON-DIE ECC CHECK BITS
FROM MEMORY

904

CHECK DATA BITS FOR SINGLE
BIT ERRORS USING ON-DIE
ECC CHECK BITS AND
CORRECT AS NEEDED

906

CHECK PARITY
CONDITIONS FOR
EACH BURST

908

RECALCULATE PARITY
CONDITIONS

910

SEND DATA BITS AND
MEMORY CONTROLLER
ECC CHECK BITS
TO MEMORY CONTROLLER

FIG. 9

1000

1002

RECEIVE DATA BITS AND
MEMORY CONTROLLER
ECC CHECK BITS
FROM MEMORY DEVICE

1004

CHECK DATA BITS
AGAINST MEMORY
CONTROLLER ECC CHECK
BITS AND PERFORM
CORRECTIONS AS NEEDED

1006

RETURN DATA BITS

# FIG. 10

COMPUTING PLATFORM 1100

PROCESSING
COMPONENT 1108

OTHER PLATFORM
COMPONENTS
1110

CIRCUITRY 1106

MEMORY
CONTROLLER
104

MEMORY
CONTROLLER
ECC
COMPONENT
114

MEMORY
DEVICE (S)
102

ON-DIE ECC
COMPONENT
110

MEMORY 112

COMMUNICATIONS
INTERFACE
1112

FIG. 11

Europäisches
Patentamt

European
Patent Office

Office européen
des brevets

# EUROPEAN SEARCH REPORT

Application Number

EP 19 15 0434

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2017/192626 A1 (INTEL CORP [US]) 9 November 2017 (2017-11-09) | 1,4,7, 10,11 | INV. G11C29/52 |
| Y | * paragraph [0036]; figures 2,3A,3B,4A,4B,5 * | 2,3,5,6, 8,9 | G06F11/10 |
| Y | US 2018/024878 A1 (DAS DEBALEENA [US] ET AL) 25 January 2018 (2018-01-25) * paragraph [0024] - paragraph [0036]; figures 1-3 * | 2,3,5,6, 8,9 | |
| X | US 2008/094811 A1 (HAZELZET BRUCE G [US]) 24 April 2008 (2008-04-24) * paragraph [0036] * * paragraph [0097]; figure 2 * | 1,2,4,5, 10,11 | |
| A | NAIR PRASHANT J ET AL: "XED: Exposing On-Die Error Detection Information for Strong Memory Reliability", 2013 21ST INTERNATIONAL CONFERENCE ON PROGRAM COMPREHENSION (ICPC); [INTERNATIONAL SYMPOSIUM ON COMPUTER ARCHITECTURE.(ISCA)], IEEE, US, 18 June 2016 (2016-06-18), pages 341-353, XP032950671, ISSN: 1063-6897, DOI: 10.1109/ISCA.2016.38 ISBN: 978-0-7695-3174-8 [retrieved on 2016-08-24] * abstract * | 1-11 | |

TECHNICAL FIELDS SEARCHED (IPC)

G06F
G11C

The present search report has been drawn up for all claims

| Place of search | Date of completion of the search | Examiner |
|---|---|---|
| The Hague | 31 May 2019 | Wolff, Norbert |

EPO FORM 1503 03.82 (P04C01)

## ANNEX TO THE EUROPEAN SEARCH REPORT
## ON EUROPEAN PATENT APPLICATION NO.

EP 19 15 0434

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2019

| Patent document cited in search report | | Publication date | Patent family member(s) | | Publication date |
|---|---|---|---|---|---|
| WO 2017192626 | A1 | 09-11-2017 | CN 109074851 A | | 21-12-2018 |
| | | | EP 3453022 A1 | | 13-03-2019 |
| | | | US 2018210787 A1 | | 26-07-2018 |
| | | | WO 2017192626 A1 | | 09-11-2017 |
| US 2018024878 | A1 | 25-01-2018 | CN 107430537 A | | 01-12-2017 |
| | | | KR 20170129703 A | | 27-11-2017 |
| | | | TW 201638966 A | | 01-11-2016 |
| | | | US 2016283318 A1 | | 29-09-2016 |
| | | | US 2018024878 A1 | | 25-01-2018 |
| | | | WO 2016160274 A1 | | 06-10-2016 |
| US 2008094811 | A1 | 24-04-2008 | CN 101169962 A | | 30-04-2008 |
| | | | US 2008094811 A1 | | 24-04-2008 |

EPO FORM P0459

For more details about this annex : see Official Journal of the European Patent Office, No. 12/82